# EUROPEAN PATENT APPLICATION

(11) **EP 4 757 085 A1**
(43) Date of publication of application: **10.06.2026**
(21) Application number: 25205598.3
(22) Date of filing: 30.09.2025
(51) Int. Cl.: H02B 1/01

(54) **FRAME STRUCTURE, MOTHERBOARD TRAY, GPU SUPPORT BRACKET OF COMPUTER CABINET**

(30) Priority: 05.12.2024 US 202463728497 P; 16.01.2025 US 202519024442
(71) Applicant: Cooler Master Technology Inc., Tapei City 114065 (TW)
(72) Inventor: KAO, Chen-Chou, 114065 Taipei City (TW); SHIH, Yun Han, 114065 Taipei City (TW)
(74) Representative: Grünecker Patent- und Rechtsanwälte PartG mbB

(57) **Abstract**

A computer cabinet includes a main frame having a frame joint and three frame beams connected to the frame joint, and support beams attached to the main frame. The frame joint is a hollow structure having a joint body and three joining members. The three joining members extend from the joint body to three different directions respectively. Each frame beam has an elongated channel positioned within each frame beam to connect with the respective joining member extending from the joint body. Each frame beam has two edges extending away from the frame beam. The two edges are extending away from each other. A plurality of frame holes are formed on each edge and used for attaching the support beams.

## Description

### TECHNICAL FIELD

The present disclosure relates to computer cabinet having structures for supporting or fixing internal components.

### BACKGROUND

A modern computer cabinet typically exhibits several notable features. The cabinet comprises a rigid and durable framework, which is often constructed from high-strength metal alloys or engineered plastics, to ensure stability and protection for internal components. The cabinet can accommodate structures for support or fixing internal components, such as a motherboard, a graphics processing unit (GPU) assembly, and the like. Additionally, the cabinet provides other structures, such as cable management channels and grommets, ventilation openings, and integrated cooling fans, which ensure reliable and efficient performance of the computer system housed within the cabinet.

### SUMMARY

The invention is as defined in the appended claims. Aspects of the disclosure provide a computer cabinet. The computer cabinet can include a main frame having a frame joint and three frame beams connected to the frame joint, and support beams attached to the main frame. The frame joint is a hollow structure having a joint body and three joining members. The three joining members extend from the joint body to three different directions respectively. Each frame beam has an elongated channel preformed within each frame beam to receive the respective joining member extending from the joint body. Each frame beam has two edge strips extending away from the channel-part of the frame beam in different directions. A plurality of frame holes are formed on each edge strips and used for attaching the support beams.

In an embodiment, each joining member has at least one joining hole. Each frame beam has at least one frame beam hole that is positioned on a side wall of the elongated channel and corresponds to a respective joining hole of a joining member received in the elongated channel of the frame beam, whereby a fastener is inserted into the corresponding frame beam hole and the joining hole to join the frame joint and the frame beam together.

In an embodiment, a cross-section of the elongate channel matches with a cross-sectional profile of the respective joining member so that the beam frame and the respective joining member can be tightly joined together when the joining member is connected with the elongated channel. In an example, each frame beam is an aluminum extrusion beam.

In an embodiment, the computer cabinet further comprises a motherboard tray attached to multiple support beams laterally attached to the main frame. The motherboard tray includes a base plate that is vertically positioned and has an inward surface and an outward surface with respect to the computer cabinet. Multiple L-shaped hook structures protrude from the outward surface of the base plate. Each L-shaped hook structure has a first portion perpendicular to the base plate and a second portion parallel to the base plate. A first type of the hook structures has a longer first portion compared to a second type of the hook structures, so that the second portion of the first type of the hook structures is in contact with an exterior side of the multiple support beams laterally attached to the main frame, and the second portion of the second type of the hook structures is in contact with an interior side of the multiple support beams laterally attached to the main frame. The multiple L-shaped hook structures allow the motherboard tray to slide along the support beams during installation and be arranged at an intended position to match with a form factor of a specific mother board model.

In an embodiment, the second type of hook structures have screw holes configured to receive screws that pass through the second portion of the second type of the hook structures and are screwed into the support beams laterally attached to the main frame to fasten the motherboard tray to the support beams. In an example, the second portion of the second type of the hook structures extends upwardly or downwardly from the respective first portion of the second type of the hook structures. In an example, a pattern of holes on the base plate of the motherboard tray is configured to support motherboards of various form factors.

In an embodiment, the computer cabinet further includes a graphics processing unit (GPU) support bracket affixed to a frame beam of the main frame. The GPU support bracket includes a base structure having a first side plate and a second side plate formed integrally and extending in the vertical direction. A cross section of the base structure has a right-angled L shape. The second side plate of the base structure has an elongated slot thereon. The GPU support bracket further include an arm structure having an arm plate and a top plate on top of the arm plate. The arm plate has a pair of vertically arranged screw holes at lower end of the arm plate. The pair of screw holes is aligned with the elongated slot. A pair of manual screws pass through the elongated slot and are screwed into the pair of screwed holes to affix the arm structure to the base structure.

In an embodiment, the first side plate of the base structure has screw holes at lower end of the first side plate, and the GPU bracket is affixed to the frame beam of the main frame by screws passing through frame holes of the frame beam and screwed into the screw holes of the first side plate. In an embodiment, the first side plate has a tongue-shaped plate at the lower end of the first side plate. The bottom edge of the tongue-shaped plate touches an edge strip of the frame beam to which the GPU bracket is affixed. A top edge of the arm plate is aligned with an edge of the top plate. The elongated slot allows the arm structure to be positioned at a desired position in the vertical direction.

In an embodiment, the arm plate of the arm structure has an additional pair of vertically arranged screw holes that allow the arm structure to be positioned further into the computer cabinet so that the position of the top plate can be adaptable to various dimensions of a GPU assembly. A cushion pad is attached to a top surface of the top plate of the arm structure for protection purpose as a buffer between the top surface of the top plate of the arm structure and the bottom of the GPU assembly. The first side plate of the base structure of the GPU support bracket is fastened to the frame beam at a position that is adjustable depending on dimensions of a GPU assembly. The computer cabinet can further include cover plates attached to the main frame to enclose internal components or structures within the computer cabinet.

### BRIEF DESCRIPTION OF THE DRAWINGS

Various embodiments of this disclosure that are proposed as examples will be described in detail with reference to the following figures, wherein like numerals reference like elements, and wherein:
FIG. 1 shows a computer cabinet 100 having a main frame 1 and support beams 21-23 attached to the main frame 1.
FIG. 2 shows the main frame 1 that has eight frame joints 10 at eight corners and twelve frame beams 11 each positioned between two corresponding frame joints 10.
FIG. 3 shows a perspective view of a corner of the main frame 1 where one frame joint 10 and three frame beams 11 are disassembled from each other.
FIG. 4 shows a perspective view of the corner of the main frame 1 shown in FIG. 3, but with the frame joint 10 and the three frame beams 11 assembled together.
FIG. 5 shows a perspective view of the corner of the main frame 1 shown in FIG. 4, but from inside of the computer cabinet 100.
FIG. 6 shows a perspective view of a frame beam 11.
FIG. 7 shows a perspective view of the computer cabinet 100 where the motherboard tray 6 is attached to one side of the computer cabinet 100.
FIG. 8 shows the motherboard tray 6.
FIG. 9 shows multiple lateral support beams 21 attached to the main frame 1 at one side of the computer cabinet 100.
FIG. 10 shows the motherboard tray 6 being engaged with and affixed to the multiple lateral support beams 21 by the hook structures 62/63.
FIG. 11 shows a perspective view of a computer cabinet 100 with a graphics processing unit (GPU) support bracket 7.
FIG. 12 shows a zoomed-in view of the installation of the GPU support bracket 7.
FIG. 13 and FIG. 14 show more details of the GPU support bracket 7 in two views with different perspectives.

### DETAILED DESCRIPTION OF EMBODIMENTS

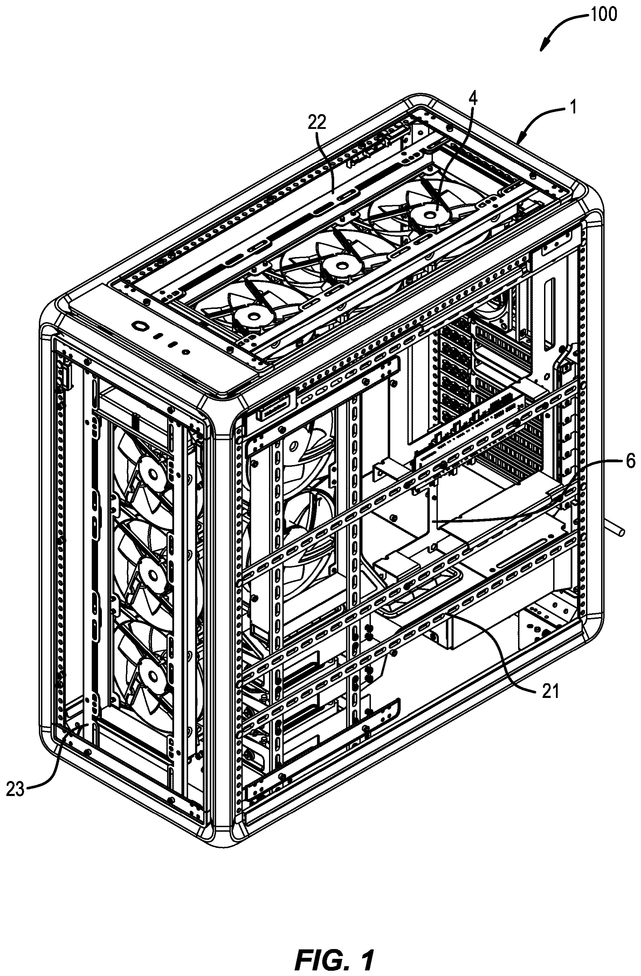

FIG. 1 shows a computer cabinet 100 having a main frame 1 and support beams 21-23 attached to the main frame 1. Electronic components, such as fans 4, and structures for supporting or fixing electronic components, such as a motherboard tray 6, can be attached to the main frame 1 or the respective support beams 21-23 within the computer cabinet 100. Cover plates or panels (not shown) of the computer cabinet 100 can be attached to the main frame 1 or the support beams 21-23, enclosing internal components or structures within the computer cabinet 100. As shown, the motherboard tray 6 is attached to multiple lateral support beams 21.

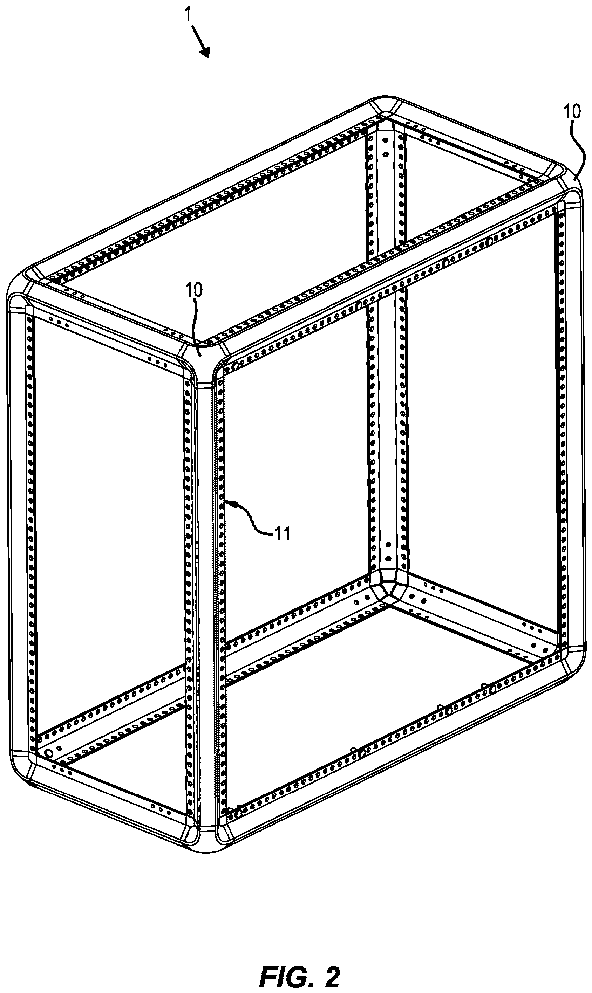

FIG. 2 shows the main frame 1 that has eight frame joints 10 at eight corners and twelve frame beams 11 each positioned between two corresponding frame joints 10.

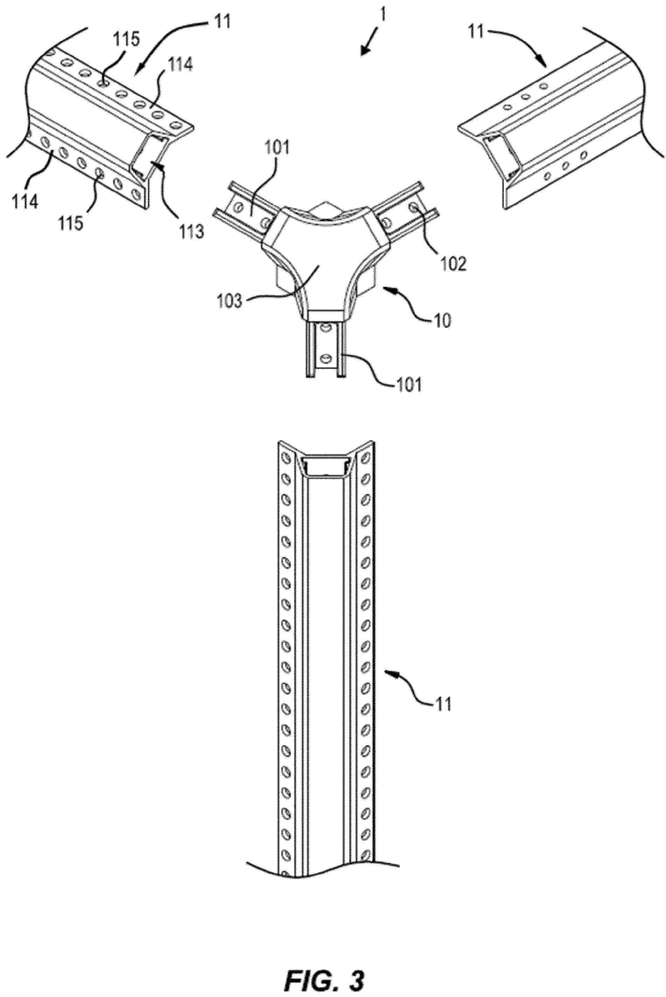

FIG. 3 shows a perspective view of a corner of the main frame 1 where one frame joint 10 and three frame beams 11 are disassembled from each other. As shown, the frame joint 10 has a joint body 103 and three joining members 101. The three joining members 101 extend from the joint body 103 to three different directions respectively. In an example, the three joining members 101 are perpendicular to each other. Each joining member 101 has at least one joining hole 102. The joining hole 102 can be a threaded hole or an un-threaded hole.

Each frame beam 11 has a hollow structure. An elongated channel 113 of preferably polygonal section is positioned within each frame beam 11 to connect with the respective joining member 101 extending from the joint body 103. The cross-section of the elongated channel 113 precisely matches with the cross-sectional profile of the respective joining member 101 so that the beam frame 11 and the respective joining member 101 can be tightly joined together when the joining member 101 is connected with the elongated channel 113.

Each frame beam 11 has two edge strips (edge members) 114 extending away from the channel-part of the frame beam 11 in different directions. The two edge strips 114 preferably extend from different corners of the channel-part of the frame beam 11. In an example, the two edge strips 114 are perpendicular to each other. A plurality of frame holes 115 can be formed on each edge strip 114. The frame holes 115 can be threaded or unthreaded and used for connecting with support beams 21-23 or other components or structures of the computer cabinet 100.

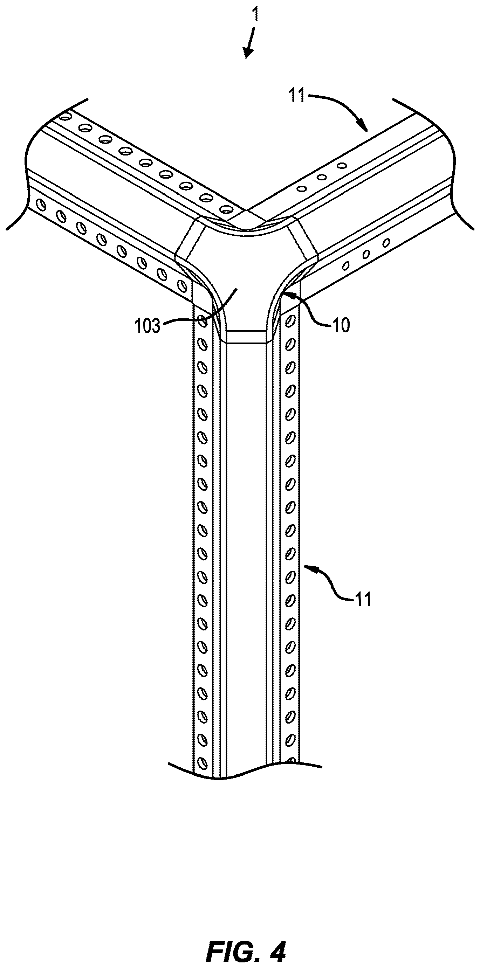

FIG. 4 shows a perspective view of the corner of the main frame 1 shown in FIG. 3, but with the frame joint 10 and the three frame beams 11 assembled together.

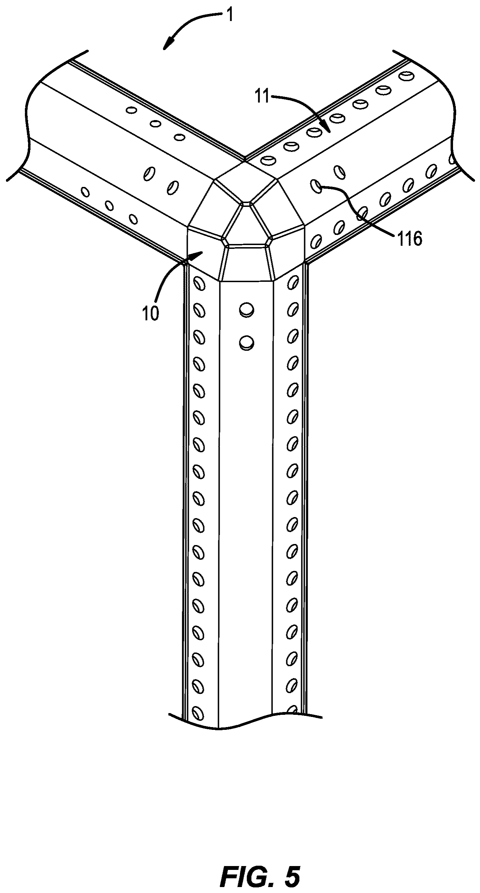

FIG. 5 shows a perspective view of the corner of the main frame 1 shown in FIG. 4, but from inside of the computer cabinet 100. As shown, each frame beam 11 has at least one threaded or unthreaded frame beam hole 116 corresponding to a respective joining hole 102 of a joining member 101 connected with the elongate channel 113 of the frame beam 11. A fastener (not shown), such as a threaded screw, can be inserted into the corresponding frame beam hole 116 and the joining hole 102. As a result, the frame joint 10 and the three frame beams 11 can be joined together tightly.

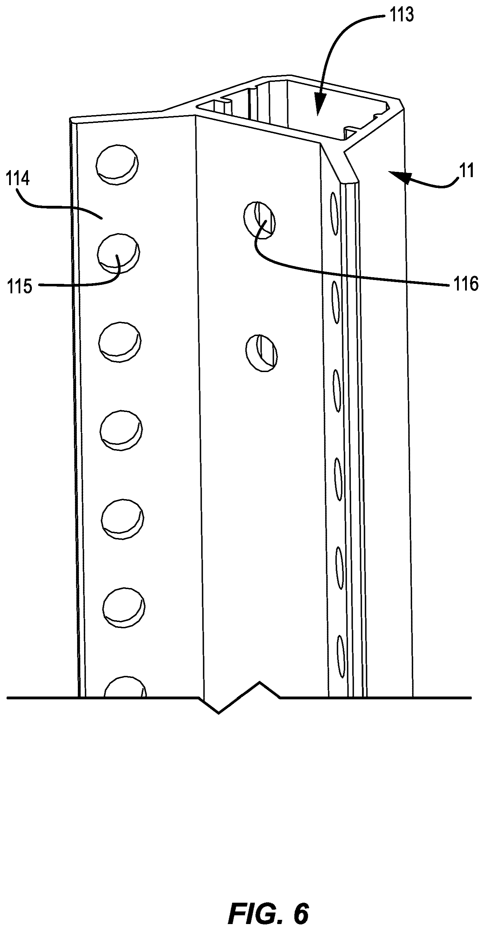

FIG. 6 shows a perspective view of a frame beam 11 that has an elongated channel 113, a plurality of frame holes 115 preformed on two edge strips 114 of the frame beam 11, and two frame beam holes 116 preformed on a side wall of the elongated channel 113. In some examples, the frame beam 11 can be aluminum (AL) extrusion beams.

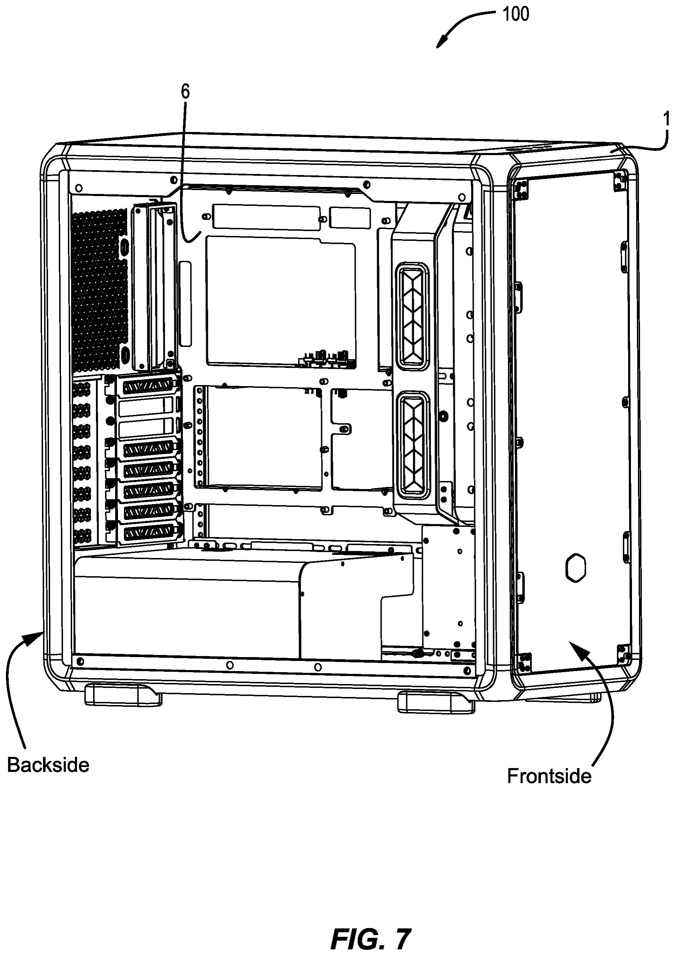

FIG. 7 shows a perspective view of the computer cabinet 100 where the motherboard tray 6 is attached to one side of the computer cabinet 100.

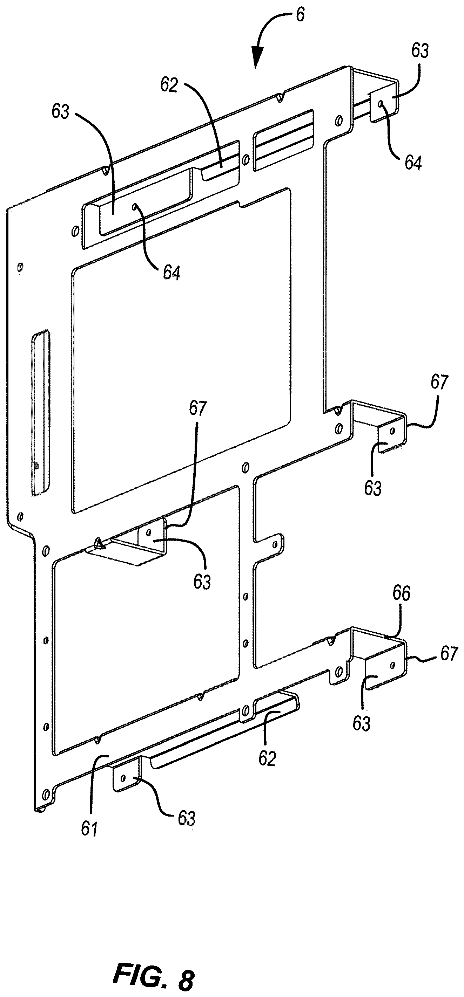

FIG. 8 shows the motherboard tray 6. The motherboard tray 6 has a base plate 61 having an inward surface and an outward surface with respect to the computer cabinet 100. The base plate 61 has holes whose pattern matches with motherboards of various form factors. The base plate 61 also has slots and cutouts which are either positioned for ease of installation of motherboard tray 6 or preformed to save materials or reduce structural weight.

Multiple L-shaped hook structures 62/63 protrude from the outward surface of the base plate 61. The first portion 66 of each L-shaped hook structure 62/63 (vertical leg 66 of the L shape) is perpendicular to the base plate 61 and serves as a vertical anchoring element. The second portion 67 of each L-shaped hook structure 62/63 (67 lateral leg of the L shape) is in parallel to the base plate 61. There are two variants of these hook structures 62/63. The first type of hook structures 62 features a longer vertical leg compared to the second type of hook structures 63.

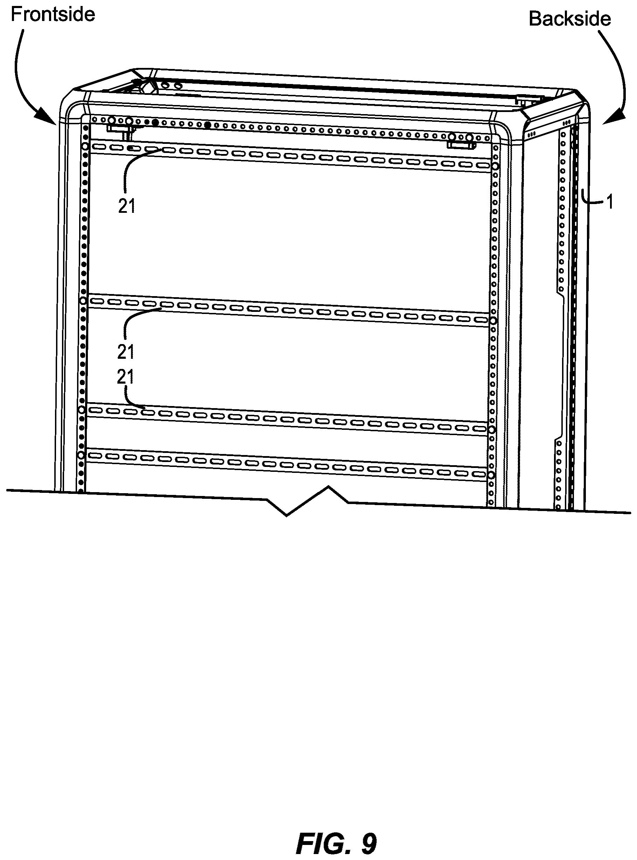

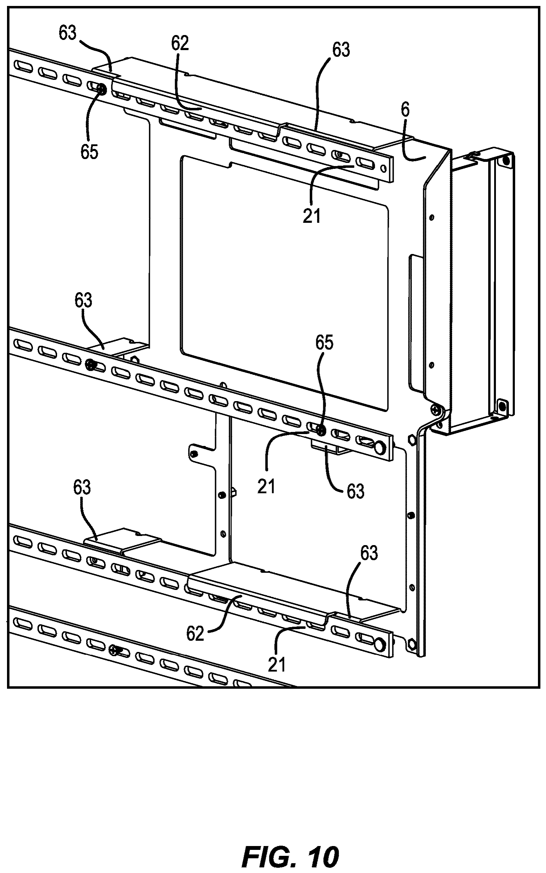

FIG. 9 shows multiple lateral support beams 21 attached to the main frame 1 at one side of the computer cabinet 100. FIG. 10 shows the motherboard tray 6 being engaged with and affixed to the multiple lateral support beams 21 by the hook structures 62/63. As shown, the lateral legs of the first type of hook structures 62 make contact with the exterior sides of the support beams 21, and the lateral legs of the second type of hook structures 63 interface with the interior sides of the support beams. This differential attachment of the two types of hook structures 62/63 ensures a secure and stable vertical mounting of the motherboard tray 6 onto the support beams 21, with the L-shaped hook structures effectively distributing and managing the forces involved in the attachment.

The hook structure 62/63 allows for easy installation of a motherboard and other components. With the hook structures 62/63, during the installation, the motherboard tray 6 can slide along the support beams 21 and be arranged at an intended position to match with the form factor of a specific motherboard model. Thus, the position of the motherboard tray 6 can be flexibly adjusted to satisfy the requirement of mounting motherboards with various form factors.

As shown in FIG. 8, the second type of hook structures 63 has screw holes 64. As shown in FIG. 10, screws 65 can pass through the lateral support beams 21 and be screwed into the screw holes 64 in the hook structures 63. Such a fastening mechanism ensures the motherboard tray 6 is firmly mounted onto the support beams 21. In addition, as shown in FIG. 8, the lateral legs 67 of the second type of hook structures 63 can extend upwardly or downwardly from the respective vertical legs.

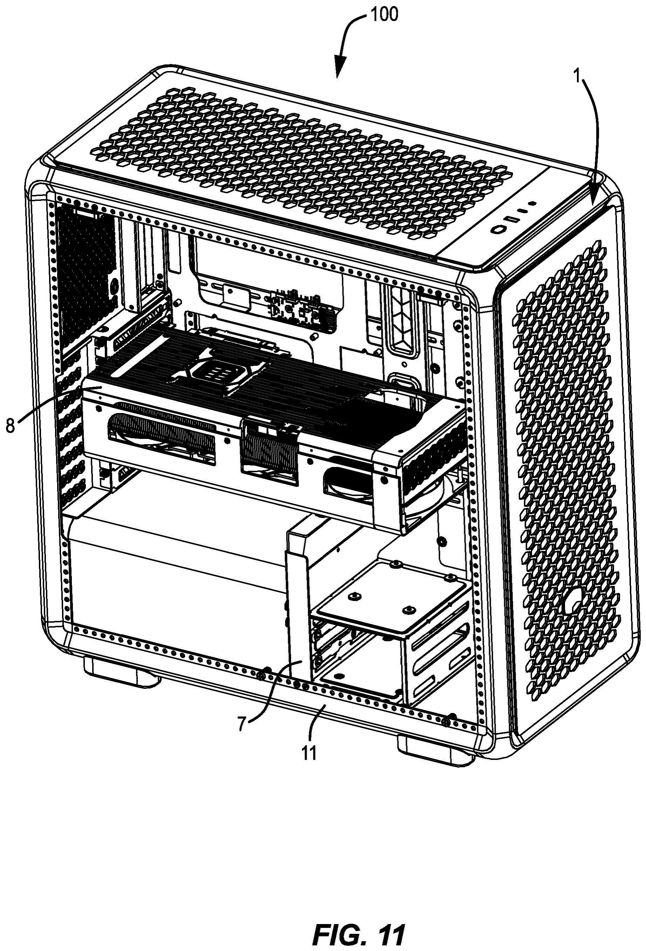

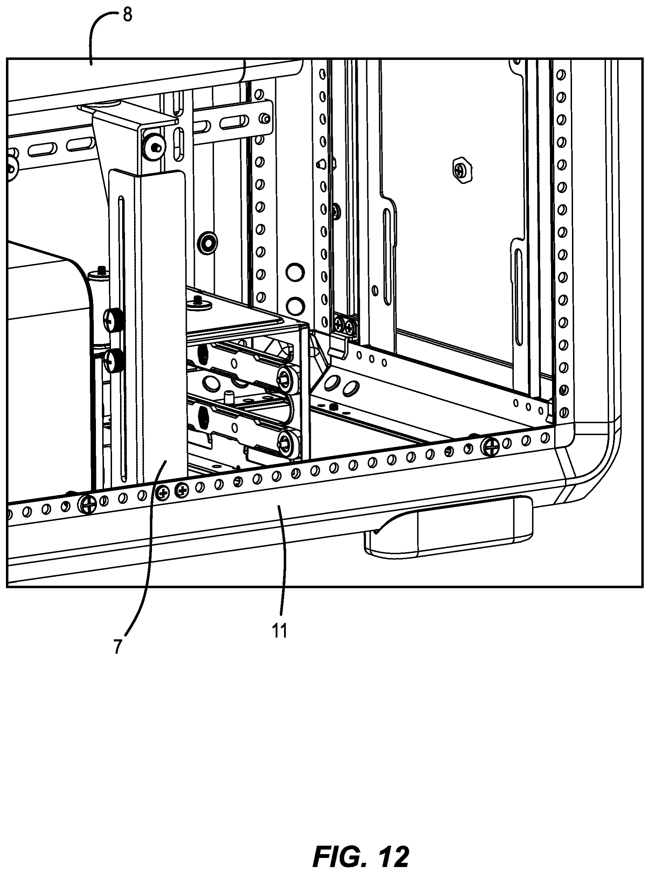

FIG. 11 shows a perspective view of a computer cabinet 100 with a graphics processing unit (GPU) support bracket 7. The GPU support bracket 7 is affixed to a frame beam 11 of a main frame 1 of the computer cabinet 1. A GPU assembly 8 is installed inside the computer cabinet 100. The GPU support bracket 7 bears the weight of the GPU assembly 8 and provides stability to the GPU during operation. FIG. 12 shows a zoomed-in view of the installation of the GPU support bracket 7.

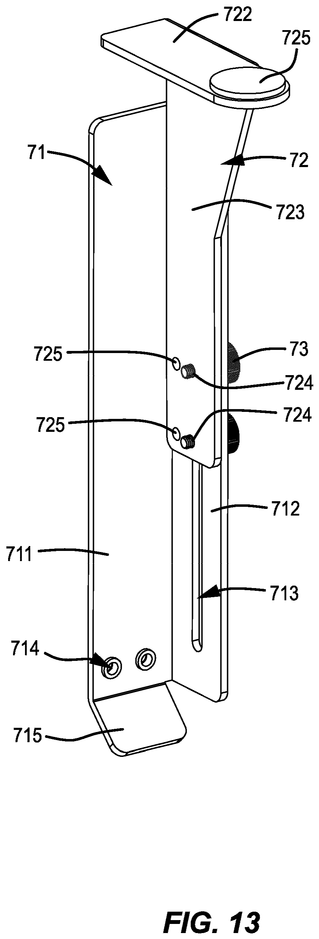

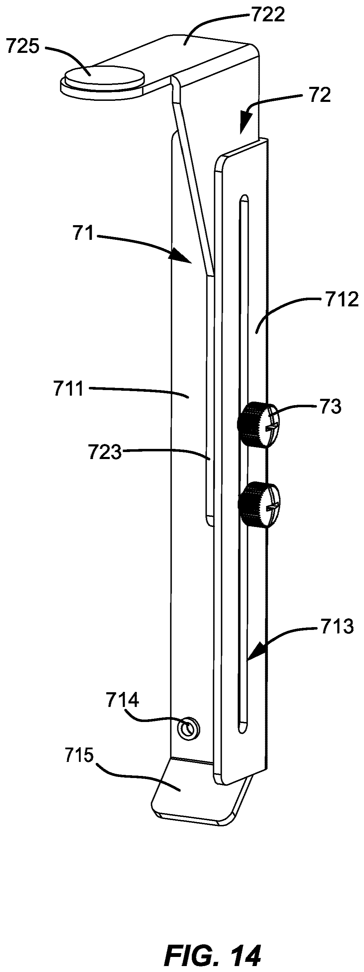

FIG. 13 and FIG. 14 show more details of the GPU support bracket 7 in two views with different perspectives. As shown, the GPU support bracket 7 has a base structure 71 and an arm structure 72. The base structure 71 has an elongated slot 713 on the side where the arm structure 72 is mounted extending in the vertical direction. The arm structure 72 is mounted to the base structure 71 by a fastening scheme in a way that the arm structure 72 can slide upwards or downwards along the elongated slot 713 during installation. In this way, the height of GPU support bracket 7 can be adjusted to adapt to the vertical position of the GPU assembly 8. In this disclosure, the vertical direction is a direction perpendicular to the bottom of the computer cabinet 100 shown in FIG. 1.

The base structure 71 has a first side plate 711 and a second side plate 712. The plates 711 and 712 are formed integrally and extend in the vertical direction. A cross section of the base structure 71 has a right-angled L shape. The first side plate 711 has screw holes 714 at its lower end for fastening it to a suitable position on the frame beam 11. Depending on the dimensions of the GPU assembly 8, the position of the GPU bracket 7 along the frame beam 11 can be suitably adjusted. The first side plate 711 further has a tongue-shaped plate 715, the bottom edge of which touches an edge strip 114 of the frame beam 11 to further enforce the base structure 71. The second side plate 712 has the elongated slot 713 thereon.

The arm structure 72 has an arm plate 723 and a top plate 722 on top of the arm plate 723. The top edge of the arm plate 723 is aligned with an edge of the top plate 722. The arm plate 723 has a pair of vertically arranged screw holes 724 at its lower end. The pair of screw holes 724 are aligned with the elongated slot 713. A pair of manual screws 73 pass through the elongated slot 713 and are screwed into the pair of screwed holes 724, affixing the arm structure 72 to the base structure 71 tightly. The elongated slot 713 allows the arm structure 72 to be positioned at any desired position in the vertical direction so that the height of the GPU support structure 7 can match with the height defined between the bottom of the GPU assembly 8 and the bottom of the computer cabinet 100. In addition, there can be an additional pair of screw holes 725 that allow the arm structure 72 to be positioned closer to the center of the computer cabinet 100 so that the position of the top plate 722 can be adaptable to various dimensions of GPU assembly 8. As shown, a cushion pad 725 is attached to the top surface of the top plate 722 for the protection purpose as a buffer between the top surface of the top plate 72 and the bottom of the GPU assembly 8.

Structures or elements described in this disclosure, such as the main frame 1, the motherboard tray 6, and the GPU support bracket 7, can be made of metal (such as steel, aluminum, or the like) for strength and rigidity. In some cases, plastic materials or other types of materials can be employed.

While aspects of the present disclosure have been described in conjunction with the specific embodiments thereof that are proposed as examples, alternatives, modifications, and variations to the examples may be made. Accordingly, embodiments as set forth herein are intended to be illustrative and not limiting. There are changes that may be made without departing from the scope of the claims set forth below.

## Claims

1. A computer cabinet (100), comprising:
a main frame (1) having a frame joint (10) and three frame beams (11) connected to the frame joint (10); and
support beams (21-23) attached to the main frame (1),
wherein the frame joint (10) is a hollow structure having a joint body (103) and three joining members (101), the three joining members (101) extend from the joint body (103) to three different directions respectively, and
each frame beam (11) has an elongated channel (113) positioned within each frame beam (11) to connect with the respective joining member (101) extending from the joint body (103), each frame beam (11) has two edge strips (114) extending away from the channel-part of the frame beam (11) in different directions, a plurality of frame holes (115) formed on each edge strip (114) and used for attaching the support beams (21-23).

2. The computer cabinet (100) of claim 1, wherein each joining member (101) has at least one joining hole (102), each frame beam (11) has at least one frame beam hole (116) that is positioned on a side wall of the elongated channel (113) and corresponds to a respective joining hole (102) of a joining member (101) connected with the elongated channel (113) of the frame beam (11), whereby a fastener is inserted into the corresponding frame beam hole (116) and the joining hole (102) to join the frame joint (10) and the frame beam (11) together.

3. The computer cabinet (100) of claim 1, wherein a cross-section of the elongate channel (113) matches with a cross-sectional profile of the respective joining member (101) so that the frame beam (11) and the respective joining member (101) can be tightly joined together when the joining member (101) is connected with the elongated channel (113).

4. The computer cabinet (100) of claim 1, wherein each frame beam (11) is an aluminum extrusion beam.

5. The computer cabinet (100) of claim 1, further comprising:
a motherboard tray (6) attached to multiple support beams (21-23) laterally attached to the main frame (1), the motherboard tray (6) including:
a base plate (61) that is vertically positioned and has an inward surface and an outward surface with respect to the computer cabinet (100); and
multiple L-shaped hook structures (62/63) protruding from the outward surface of the base plate (61), each L-shaped hook structure (62/63) having a first portion (66) perpendicular to the base plate (61) and a second portion (67) parallel to the base plate (61),
wherein a first type of the hook structures (62) having a longer first portion (66) compared to a second type of the hook structures (63), so that the second portion (67) of the first type of the hook structures (62) is in contact with an exterior side of the multiple support beams (21-23) laterally attached to the main frame (1), and the second portion (67) of the second type of the hook structures (63) is in contact with an interior side of the multiple support beams (21-23) laterally attached to the main frame (1).

6. The computer cabinet (100) of claim 5, wherein the multiple L-shaped hook structures (62/63) allow the motherboard tray (6) to slide along the support beams (21-23) during installation and be arranged at an intended position to match with a form factor of a specific mother board model.

7. The computer cabinet (100) of claim 5, wherein the second type of hook structures (63) have screw holes (64) configured to receive screws (65) that pass through the second portion (67) of the second type of the hook structures (63) and are screwed into the support beams (21-23) laterally attached to the main frame (1) to fasten the motherboard tray (6) to the support beams (21-23).

8. The computer cabinet (100) of claim 7, wherein the second portion (67) of the second type of the hook structures (63) extends upwardly or downwardly from the respective first portion (66) of the second type of the hook structures (63).

9. The computer cabinet (100) of claim 5, wherein a pattern of holes on the base plate (61) of the motherboard tray (6) is configured to support motherboards of various form factors.

10. The computer cabinet (100) of claim 1, further comprising a graphics processing unit (GPU) support bracket (7) affixed to a frame beam (11) of the main frame (1), the GPU support bracket (7) including:
a base structure (71) having a first side plate (711) and a second side plate (712) formed integrally and extending in the vertical direction, a cross section of the base structure (71) having a right-angled L shape, the second side plate (712) having an elongated slot (713) thereon; and
an arm structure (72) having an arm plate (723) and a top plate (722) on top of the arm plate (723), the arm plate (723) having a pair of vertically arranged screw holes (724) at lower end of the arm plate (723), the pair of screw holes (724) being aligned with the elongated slot (713), a pair of manual screws (73) passing through the elongated slot (713) and being screwed into the pair of screwed holes (724) to affix the arm structure (72) to the base structure (71).

11. The computer cabinet (100) of claim 10, wherein the first side plate (711) has screw holes (714) at lower end of the first side plate (711), and the GPU bracket (7) is affixed to the frame beam (11) of the main frame (1) by screws passing through frame holes (115) of the frame beam (11) and screwed into the screw holes (714) of the first side plate (711).

12. The computer cabinet (100) of claim 11, wherein the first side plate (711) has a tongue-shaped plate (715) at the lower end of the first side plate (711), the bottom edge of which touches an edge strip (114) of the frame beam (11) to which the GPU bracket (7) is affixed.

13. The computer cabinet (100) of claim 10, wherein a top edge of the arm plate (723) is aligned with an edge of the top plate (722).

14. The computer cabinet (100) of claim 10, wherein the elongated slot (713) allows the arm structure (72) to be positioned at a desired position in the vertical direction.

15. The computer cabinet (100) of claim 10, wherein the arm plate (723) of the arm structure (72) has an additional pair of vertically arranged screw holes (725) that allow the arm structure (72) to be positioned closer to the center of the computer cabinet (100) so that the position of the top plate (722) can be adaptable to various dimensions of a GPU assembly (8).

16. The computer cabinet (100) of claim 10, further comprising a cushion pad (725) attached to a top surface of the top plate (722) of the arm structure (72).

17. The computer cabinet (100) of claim 10, wherein the first side plate (711) of the base structure (71) of the GPU support bracket (7) is fastened to the frame beam (11) at a position that is adjustable depending on dimensions of a GPU assembly (8).

18. The computer cabinet (100) of claim 10, further comprising cover plates attached to the main frame (1) to enclose internal components or structures within the computer cabinet (100).
